# EUROPEAN PATENT SPECIFICATION

(11) **EP 1 117 714 B1**
(45) Date of publication and mention of the grant of the patent: **27.11.2002**
(21) Application number: 99932807.3
(22) Date of filing: 03.07.1999
(51) Int. Cl.: C08F 246/00, C08F 8/48, G03F 7/023

(54) **WATER SOLUBLE POSITIVE-WORKING PHOTORESIST COMPOSITION**
WASSERLÖSLICHE POSITIV ARBEITENDE PHOTORESISTZUSAMMENSETZUNG
COMPOSITION DE RESINE NEGATIVE SOLUBLE DANS L'EAU

(30) Priority: 23.07.1998 US 121285
(43) Date of publication of application: 25.07.2001
(73) Proprietor: Clariant Finance (BVI) Limited, Road Town, Tortola (VG)
(72) Inventor: McCULLOCH, Iain, Basking Ridge, NJ 07920 (US); EAST, Anthony, J., Madison, NJ 07940 (US); KANG, Ming, Colonia, NJ 07067 (US); KEOSIAN, Richard, Nazareth, PA 18064 (US); YOON, Hyun-Nam, New Providence, NJ 07947 (US)
(74) Representative: Hütter, Klaus, Dr.
(86) International application number: EP9904636
(87) International publication number: WO00005282

(56) References cited:
- EP-A- 0 501 308
- US-A- 5 665 841
- US-A- 5 723 258

## Description

### BACKGROUND OF THE INVENTION

The present invention is directed to water soluble polymers that are useful as a positive working water soluble photoresist.

Photoresist compositions are used in microlithography processes for making miniaturized electronic components such as in the fabrication of computer chips and integrated circuits. Generally, in these processes, a thin coating or film of a photoresist composition is first applied to a substrate material, such as silicon wafers used for making integrated circuits. The coated substrate is then heated to evaporate any solvent in the photoresist composition and to fix the coating onto the substrate. The coated surface of the substrate is next masked and subjected to exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this masked exposure, the coated substrate is treated with a developer solution to dissolve and remove either the radiation-exposed or the unexposed areas of the coated surface of the substrate.

There are two types of photoresist compositions, negative-working and positive-working. When negative-working photoresist compositions are exposed to radiation, the areas of the resist composition exposed to the radiation become less soluble to a developer solution while the unexposed areas of the photoresist coating remain soluble to such a solution. Thus, treatment of an exposed negative-working resist with a developer causes removal of the non-exposed areas of the photoresist coating and the creation of a negative image in the coating, thereby uncovering a desired portion of the underlying substrate surface on which the photoresist composition was deposited.

On the other hand, when positive-working photoresist compositions are exposed to radiation, those areas of the photoresist composition exposed to the radiation become more soluble to the developer solution while those areas not exposed remain insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After development, the now partially unprotected substrate may be treated with a substrate-etchant solution or plasma gas and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Photoresist resolution is defined as the smallest feature which the resist composition can transfer from the photomask to the substrate with a high degree of image edge acuity after exposure and development. In most manufacturing applications today, resist resolution on the order of less than one micron is necessary. Photolithographic process have progressed from visible light to ultraviolet light (so called i-line at wavelengths around 365 nm) and beyond. In addition, it is almost always desirable that the developed photoresist wall profiles be near vertical relative to the substrate. Such demarcations between developed and undeveloped areas of the resist coating translate into accurate pattern transfer of the mask image onto the substrate.

Generally, positive working photoresists are preferred over negative working photoresists as they generally exhibit superior resolution capabilities. The present positive working photoresist is capable of operation at i-line wavelengths. The present photoresist compositions are water soluble and thus environmentally friendly on application to a substrate.

### SUMMARY OF THE INVENTION

The present invention is directed to water soluble polymers that form a positive working water soluble photoresist that does not require the use of a photoacid generator. The present photoresist can be used at fine resolutions at i-line wavelengths. Further since the solvent used with the present photoresist is water, the use of this photoresist in semiconductor manufacturing will be environmentally friendly. The polymer is comprised of a suitable backbone, such as polyvinyl ether, coupled by a linkage group to a β-keto carboxylate salt. A second linkage group couples a sulfonated diazonapthoquinone (DNQ) moiety to the backbone. The choice of backbone and any comonomer, is influenced by its solubility in water, as the initial polymer must be sufficiently soluble in water to provide a suitable formulation viscosity. After application to a substrate the photoresist composition is transformed to a water insoluble state by heating. This will cause the β-keto carboxylate salt to undergo both Hoffamn degradation followed by decarboxylation which liberates ammonia and CO₂. The polymer product from this thermal elimination is now insoluble in water. On subsequent exposure to i-line irradiation, the DNQ moiety undergoes a Wolff rearrangement which, via a ketene intermediate, ultimately yields an indene carboxylic acid. The polymer product from this photochemical rearrangement is now soluble in water. As the starting polymer undergoes two solubility switches, from water soluble to insoluble (after heating) and back to soluble (after photochemistry), the photoresist will dissolve in developer when developed from an aqueous base and hence create a positive image.

### DESCRIPTION OF THE PREFERRED EMBODIMENTS

The present invention is directed to a polymer particularly suitable for use as a photoresist The polymer is essentially comprised of a backbone coupled by linkage groups to two pendant groups. The first group is a β-keto carboxylate moiety (as a salt or acid) (2-substituted 3-oxobutanoic acid). This functional group is designed to undergo a thermal polarity switch to a water-insoluble ketone. A second linkage group couples a diazonapthoquinone (DNQ) moiety via a 4-sulfonate group, to the backbone. This group undergoes a photochemical rearrangement to a water-soluble indene carboxylic acid. The choice of backbone and any comonomer, is influenced by its solubility in water, as the initial polymer must be sufficiently soluble in water to provide a suitable formulation viscosity. Suitable backbones include vinyls, vinylethers, acrylates, methacrylates, vinyl phenolics, vinyl carboxylic acids and vinyl acrylamides. Suitable candidates for the first and second linkage groups include ester groups, phenylene groups, alkylene groups and alkeneoxy groups.

After application to a substrate the photoresist film is transformed to a water insoluble state by heating. This causes the β-keto carboxylate salt to undergo both Hoffman degradation and decarboxylation, liberating ammonia and CO₂ and yielding an aliphatic ketone. Subsequently, during the exposure fabrication step, the now water insoluble photoresist undergoes a common photochemical rearrangement reaction at the diazonaphthoquinone site, called a Wolff rearrangement which yields a ketene intermediate and ultimately an indene carboxylic acid. The polymer product, in the exposed regions, which contains the highly polar carboxylic acid group, is now soluble in aqueous base developer. As the starting polymer undergoes two solubility switches, from water soluble to insoluble (after heating) and back to soluble (after irradiation), the photoresist will create a positive image when developed from an aqueous base. The stoichiometry of β-keto carboxylate and DNQ moieties is controlled so that the polymer has both initial water solubility through sufficient concentration of carboxylate functionality, and final water solubility through sufficient concentration of indene carboxylate functionality. The indene carboxylate functionality concentration can be controlled by both the concentration of the photochemical precursor; DNQ, and the exposure dose.

The polymer is of the general structure: 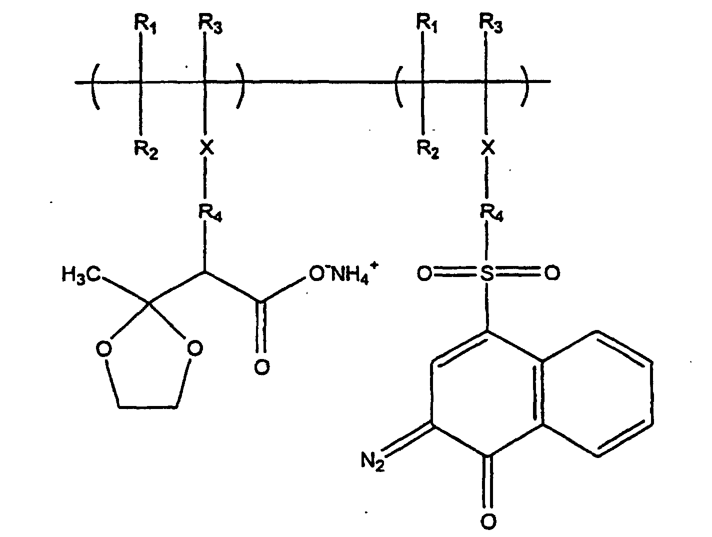 where R1-R3 are independently H, (C1-C5) alkyl or (C1-C5) alkoxy,
X is C=O, -(C=O)-O-, CONH, O, arylene, (C1-C5) alkylene, and
R₄ is (C₁-C₅) alkylene or (C₁-C₅) alkyleneoxy.

The polymers of the present invention are generally in the form of a powder which is dissolved in water to form the photoresist formulation. The photoresist formulation can be applied to a substrate by any conventional method used in the photoresist art, including dipping, spraying, whirling and spin coating. When spin coating, for example, the resist solution can be adjusted with respect to the percentage of solids content, in order to provide coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III compounds.

The photoresist coatings of the present invention are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoting layer of a suitable composition, such as one containing hexa-alkyl disilazane.

The photoresist composition solution is coated onto the substrate, and the wafer is heated so as to cause the first polarity switch. The heating causes the β-keto carboxylate moiety to undergo both Hoffman degradation and decarboxylation liberating CO₂ and ammonia, which will cause the photoresist film to become water insoluble. The temperature and time of the heating step is adjusted, dependent on both coating thickness and the need for all of the β-keto carboxylate moieties to undergo thermal elimination without thermally degrading any DNQ moieties.

The coated substrate is then exposed to i-line radiation, at a wavelength of 365nm, in any desired pattern, produced by use of suitable masks, negatives, stencils, templates, etc. Exposure to this wavelength radiation will cause a photochemical reaction at the DNQ site called a Wolff rearrangement which yields a ketene intermediate and ultimately an indene carboxylic acid. The exposed region is now soluble in aqueous base. Thus, the exposed polymer has undergone a double polarity switch from water-soluble to insoluble and back to water-soluble, which allows a positive image to be formed.

The exposed photoresist-coated substrates are developed to remove the exposed areas by immersion in an aqueous alkaline developing solution or developed by spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances.

Photoresists of the present invention may also contain other optional ingredients such as colorants, dyes, anti-striation agents, sensitizers, leveling agents, plasticizers, adhesion promoters, speed enhancers, solvents and such surfactants as non-ionic surfactants may be added to the solution of the polymer resin, sensitizer and solvent before the photoresist composition is coated onto a substrate.

The solvents may be present in the overall composition in an amount of up to 95% by weight of the solids in the composition. Solvents, of course, are substantially removed after coating of the photoresist solution on a substrate and drying. Non-ionic surfactants that may be used include, for example, nonylphenoxy poly(ethyleneoxy) ethanol; octylphenoxy ethanol.

The following chemical synthetic scheme and description of the process will provide illustrations of the methods of producing and utilizing compositions of the present invention. This is not intended, however, to limit or restrict the scope of the invention in any way and should not be construed as providing conditions, parameters or values which must be utilized exclusively in order to practice the present invention.

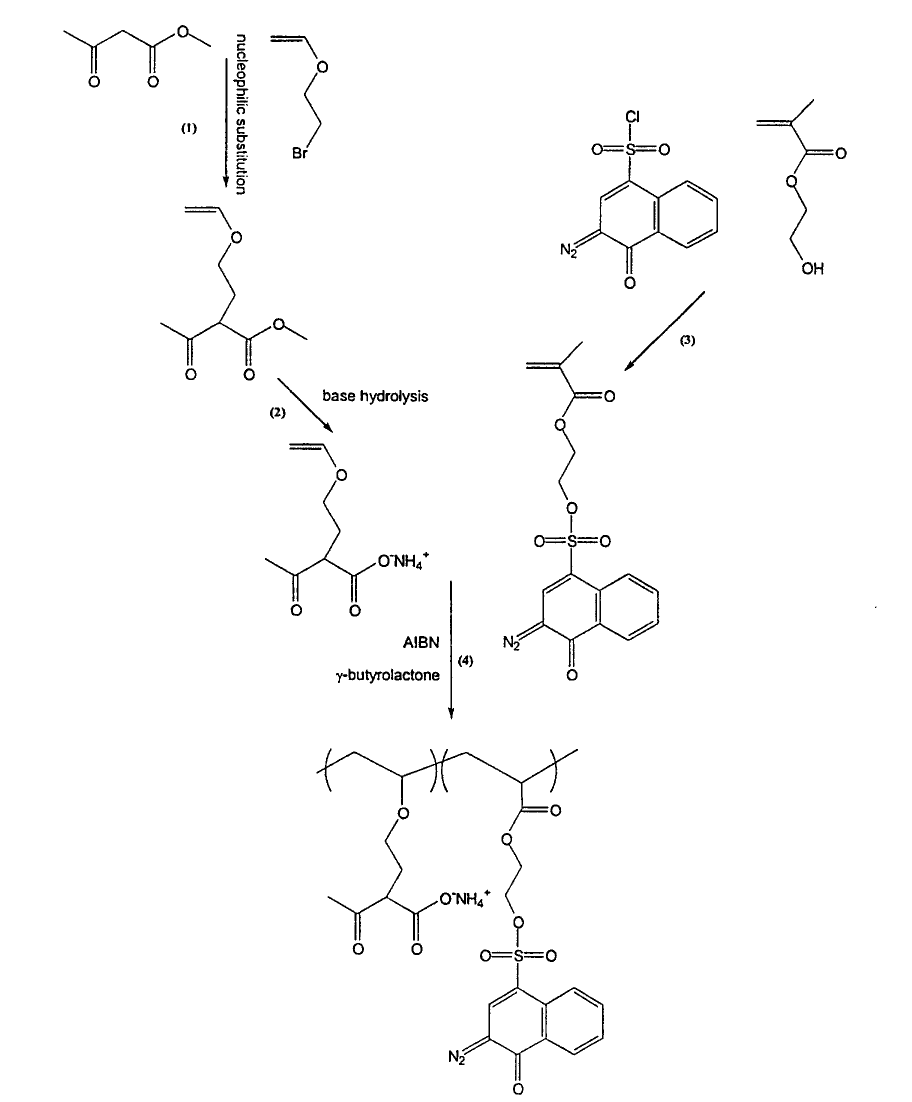

As shown in the above scheme, the alkoxyvinyl ether substituted oxobutanoate salt can be synthesized in two steps. Firstly 2-bromoethyl vinylether is subjected to a base catalyzed nucleophilic substitution reaction with the methylene carbanion of methyl acetoacetate, at the 2 position. It is necessary to maintain a basic pH, utilizing a non-nucleophilic base, to avoid degradation of the vinyl ether. The ester group is then hydrolyzed in basic conditions to the carboxylate salt as shown in reaction 2, which yields the desired alkoxyvinyl ether substituted oxobutanoate monomer. The diazonaphthoquinone sulfonate ethyl methacrylate monomer can be prepared by simple esterification of the DNQ sulfonyl chloride with 2-hydroxyethyl methacrylate. The purified monomers from reactions 2 and 3 are then polymerized as shown in reaction 4 using solution free-radical technique with AIBN initiator in γ-butyrolactone solvent The composition of the polymer is controlled by the feed ratio of the starting monomers.

## Claims

1. A polymer particularly suitable for use as a positive working photoresist, comprising all of the following:
a) a polymer backbone;
b) a β -keto carboxylate ammonium salt moiety coupled to the backbone by a first linkage group, said β-keto carboxylate moiety undergoing thermal elimination, to an alkyl ketone functionality and ammonia and carbon dioxide side products, so as to change solubility from water soluble to water insoluble on heating; and
c) a sulfonated diazonapthoquinone (DNQ) moiety coupled to the backbone by a second linkage group, said sulfonated diazonapthoquinone (DNQ) moiety undergoing a photochemical reaction to an indene carboxytic acid when exposed to radiation, so as to change solubility from water insoluble to water soluble.

2. The polymer as claimed in claim 1 wherein the β-keto carboxylate moiety is derived from an ammonium 2-(ethylvinyl ether) 3-oxobutanoate.

3. The polymer as claimed in claim 1 wherein the first and second linkage groups comprise at least one of an ester group, a phenylene group, an alkylene group and an alkeneoxy group.

4. The polymer as claimed in claim 1 wherein the backbone polymer comprises at least one moiety derived from vinylethers, acrylates, methacrylates, vinyl phenolics, vinyl carboxylic acids and vinyl acrylamides.

5. A polymer particularly suitable for use as a photoresist, comprising the structure: 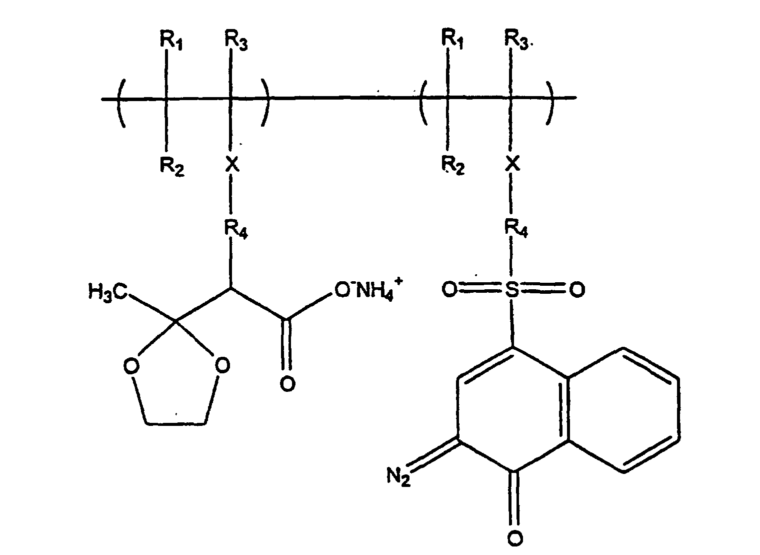 where R1-R3 are independently H, (C1-C5) alkyl or (C1-C5) alkoxy,
X is C=O, -(C=O)-O-, CONH, O, arylene, (C1-C5) alkylene,
R₄ is (C₁-C₅) alkylene or (C₁-C₅) alkyleneoxy.

6. A photoresist formulation consisting in the polymer as claimed in claim 5 dissolved in water.

## Patentansprüche

1. Polymer, besonders geeignet zur Verwendung als positiv arbeitendes Photoresist, mit allen der folgenden Bestandteile:
a) einem Polymergerüst;
b) einem β-Ketocarboxylat-Ammoniumsalz-Anteil, der durch eine erste Bindungsgruppe an das Gerüst gekoppelt ist, wobei der genannte β-Ketocarboxylat-Anteil unter Wärmewirkung beseitigt und in eine Alkylketon-Gruppe sowie in Ammoniak- und Kohlenstoffdioxid-Nebenprodukte verwandelt wird, so daß die wasserlösliche Verbindung beim Erwärmen zu einer wasserunlöslichen Verbindung wird, und
c) einem sulfonierten Diazonaphthochinon (DNQ)-Anteil, der durch eine zweite Bindungsgruppe an das Gerüst gekoppelt ist, wobei der genannte sulfonierte Diazonaphthochinon (DNQ)-Anteil durch eine photochemische Reaktion unter der Einwirkung einer Strahlung in eine Indencarbonsäure verwandelt wird, so daß die wasserunlösliche Verbindung zu einer wasserlöslichen Verbindung wird.

2. Polymer gemäß Anspruch 1, wobei der β-Ketocarboxylat-Anteil von einem Ammonium-2-(ethylvinylether)-3-oxobutanoat abgeleitet ist.

3. Polymer gemäß Anspruch 1, wobei die erste und die zweite Bindungsgruppe mindestens eine Gruppe enthalten, die aus einer Estergruppe, einer Phenylengruppe, einer Alkylengruppe und einer Alkenoxygruppe ausgewählt ist.

4. Polymer gemäß Anspruch 1, wobei das Gerüstpolymer mindestens eine Komponente enthält, die sich von Vinylethern, Acrylaten, Methacrylaten, Vinylphenolen, Vinylcarbonsäuren und Vinylacrylamiden ableitet.

5. Polymer, besonders geeignet zur Verwendung als Photoresist, mit folgender Struktur: 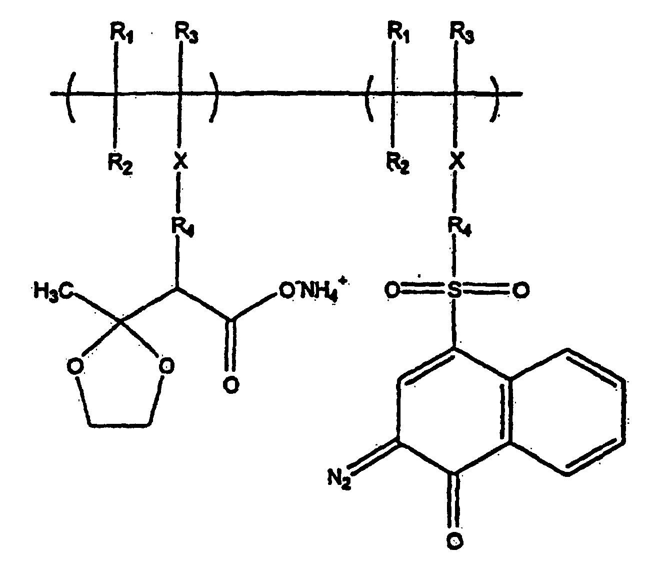 in welcher R₁-R₃, unabhängig voneinander, H, (C₁-C₅)-Alkyl oder (C₁-C₅)-Alkoxy bedeuten,
X C=O, -(C=O)-O-, CONH, O, Arylen, (C₁-C₅)-Alkylen ist und
R₄ für (C₁-C₅)-Alkylen oder (C₁-C₅)-Alkylenoxy steht.

6. Photoresistformulierung, bestehend aus dem Polymer gemäß Anspruch 5 in Wasser gelöst.

## Revendications

1. Polymère particulièrement approprié à l'utilisation comme photoresist travaillant en positif, comprenant l'ensemble de ce qui suit :
a) un squelette polymère ;
b) un fragment de sel de β-cétocarboxylate d'ammonium couplé au squelette par un premier groupe de liaison, ledit fragment β-cétocarboxylate subissant une élimination thermique, en une fonctionnalité alkylcétone et des sous-produits ammoniac et dioxyde de carbone, de manière à changer la solubilité de l'état soluble dans l'eau à insoluble dans l'eau par chauffage ; et
c) un fragment diazonaphtoquinone (DNQ) sulfoné couplé au squelette par un second groupe de liaison, ledit fragment diazonaphtoquinone (DNQ) sulfoné subissant une réaction photochimique en un acide indènecarboxylique lorsqu'il est exposé au rayonnement, de manière à changer la solubilité de l'état insoluble dans l'eau à soluble dans l'eau.

2. Polymère tel que revendiqué dans la revendication 1 dans lequel le fragment β-cétocarboxylate est dérivé d'un 2-(éthylvinyléther)-3-oxobutanoate d'ammonium.

3. Polymère tel que revendiqué dans la revendication 1 dans lequel le premier et le second groupes de liaison comprennent au moins l'un d'un groupe ester, d'un groupe phénylène, d'un groupe alkylène et d'un groupe alcènoxy.

4. Polymère tel que revendiqué dans la revendication 1 dans lequel le squelette polymère comprend au moins un fragment dérivé d'éthers de vinyle, d'acrylates, de méthacrylates, de vinylphénoliques, d'acidés vinylcarboxyliques et de vinylacrylamides.

5. Polymère particulièrement approprié à l'utilisation comme photoresist, comprenant la structure : 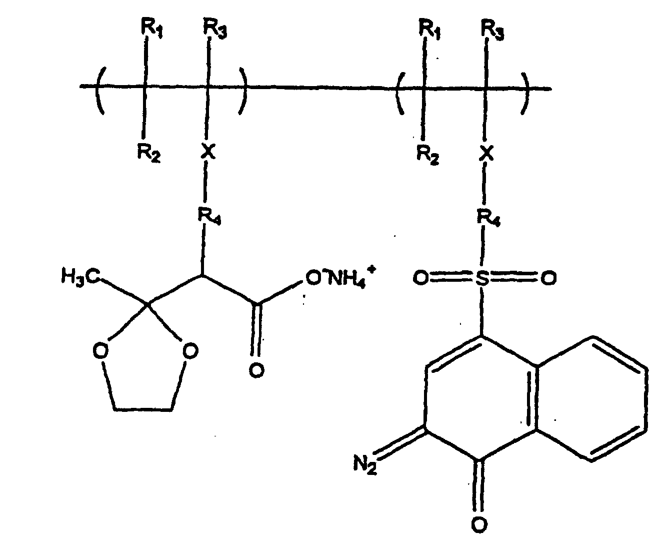 dans laquelle R₁-R₃ sont indépendamment H, un groupe alkyle en C₁-C₅ ou alcoxy en C₁-C₅,
X est C=O, -(C=O)-O-, CONH, O, arylène, alkylène en C₁-C₅, et
R₄ est un groupe alkylène en C₁-C₅ ou alkylènoxy en C₁-C₅.

6. Formulation de photoresist, constituée du polymère tel que revendiqué à la revendication 5 dissous dans l'eau.
